# EUROPEAN PATENT APPLICATION

(11) **EP 4 811 984 A1**
(43) Date of publication of application: **23.09.2026**
(21) Application number: 25165055.2
(22) Date of filing: 20.03.2025
(51) Int. Cl.: H10K 10/50, H10K 19/00, H10K 30/40, H10K 39/00

(54) **SOLAR CELL UNIT COMPRISING A SOLAR CELL AND A MEMRISTOR AND PHOTOVOLTAIC MODULE**

(71) Applicant: ZHAW - Zürcher Hochschule für Angewandte Wissenschaften, 8401 Winterthur (CH)
(72) Inventor: TRESS, Wolfgang, 8404 Winterthur (CH); MOHAMMADI, Mahdi, 8406 Winterthur (CH)
(74) Representative: E. Blum & Co. AG

(57) **Abstract**

The present invention relates to a solar cell unit (S1) comprising at least a solar cell (Sc1) and at least a memristor (M1). The memristor (M1) is connected in parallel to the solar cell (Sc1). Furthermore, the invention relates to a photovoltaic module (P) with a string of solar cell units.

## Description

### TECHNICAL FIELD

The present invention relates to a solar cell unit and a photovoltaic module comprising a string of such solar cell units in accordance with the preambles of the independent claims.

### PRIOR ART

Solar cells are known and widely used. While silicon solar cells paved the way for commercial adoption and are still wide spread, newer developments include metal halide perovskite solar cells (PSCs). Such solar cells use lead-halide perovskites, a crystal structure, which they share with calcium titanate (CaTiO₃). Perovskite solar cells are normally cheaper to manufacture and more flexible. For such PSCs, achieving high efficiency and long-term stability is crucial. PSCs now rival or surpass silicon photovoltaics in power conversion efficiency (PCE), considering low-energy and economical production processes. Despite significant advancements in the efficiency and the stability of PSCs in recent years, with devices achieving T₉₀ values exceeding thousands of hours under various standard aging tests, stability remains a challenge. In this context, the so-called "reverse bias" condition occurs in a module with solar cells connected in series, where a low-output device (potentially due to full or partial shading) is exposed to high reverse voltage generated by the photoactive solar cells. This can damage the solar cell device. Two primary strategies can be employed to mitigate negative effects of exposure to reverse bias: 1) reinforcing the device to withstand degradation caused by high reverse voltage and/or current without using any external protecting components and 2) incorporating external components, such as bypass diodes. The first strategy has not yet demonstrated sufficient success or effectiveness for perovskite photovoltaics. Furthermore, even if the cell could endure reverse bias, the absence of a bypass diode would still cause the entire series-connected cells to be blocked by the low-output cell. Therefore, the whole series connection doesn't provide any output power. The second strategy is a common solution employed in commercial silicon photovoltaics. Using a bypass diode ensures device protection during reverse bias; however, it comes with its own drawbacks, primarily related to increased cost, installation requirements, and added complexity. Increasing the breakdown voltage of PSCs could reduce overall costs by decreasing the number of bypass diodes required. However, this also means that more PSCs are protected by a single bypass diode, leading to a greater total power loss if a few devices become shaded and the bypass diode is activated. Voltage drops caused by bypass diode activation, parasitic losses, and resistive losses due to current traveling over several tens of centimeters or more within the device during reverse bias are additional disadvantages. Furthermore, certain specific applications impose size limitations that prevent the implementation of the bypass diodes.

### DESCRIPTION OF THE INVENTION

The objective of the invention is therefore to provide a technical solution that does not have the disadvantages of the prior art described above or at least partially avoids them.

This objective is reached by the subject matter of the independent claims.

According to this, the invention relates in **a first aspect** to a solar cell unit comprising at least a solar cell and at least a memristor. The memristor is connected in parallel to the solar cell.

The invention relates in **a second aspect** to a photovoltaic module comprising a string of solar cell units according to the first aspect of the invention.

In embodiments, the memristor of the solar cell unit comprises as stacked layers a first memristor electrode, a memristor semiconductor part, a second memristor electrode, and a memristor insulating layer. The insulating layer is arranged between the memristor semiconductor part and the second memristor electrode. The solar cell of the solar cell unit comprises as stacked layers a first solar cell electrode, a solar cell semiconductor part and a second solar cell electrode. The solar cell and the memristor are each arranged on a substrate layer. In one embodiment the solar cell and the memristor have each a separate own substrate layer and in an alternative embodiment the solar cell and the memristor have a common substrate layer.

In particularly preferred embodiments, the memristor semiconductor part and the solar cell semiconductor part are substantially made of a perovskite material, particularly chosen from: lead-containing all-inorganic and/or organic-inorganic hybrid perovskites, lead-free perovskite and/or oxides perovskite compositions and/or non-oxides perovskite compositions.

By using a resistive switching element, such as a memristor, in parallel to a solar cell, the latter is protected in view of reverse bias. When the solar cell is located in the shade and when light shines again on the solar cell power delivery is resumed, thereby preventing power loss. Proper design of the perovskite memristor ensures that memristor set (switching from Off-state to On-state) and reset (switching back from On-state to Off-state) occurs in reverse and forward biases respectively. Therefore, by using a two-state perovskite memristor, with resistivity of a few ohms in the On-state (e.g. between 1 and 50 Ohms) and tens of tera-ohms (e.g. between 0.1 and 1 TOhms) in the Off-state, when solar cell experiences shade, it can be protected by the On-state of the memristor triggered by reverse bias and when light returns to the solar cell, the memristor switches back to the Off-state due to forward bias, thereby preventing power loss.

### BRIEF DESCRIPTION OF THE DRAWINGS

Further preferred embodiments of the invention are apparent from the dependent claims and from the description which now follows with reference to the figures. It is shown in:
Fig. 1 a schematic lateral cross section view through a **first** embodiment of a solar cell unit according to the invention;
Fig. 2 a schematic lateral cross section view through a **second** embodiment of a solar cell unit according to the invention;
Fig. 3 a schematics of a configuration of a solar cell unit according to Fig. 2;
Fig. 4 a schematics of a configuration of a string of solar cell units according to Fig. 1 or 2;
Fig. 5 a schematic lateral section view through a **first** embodiment of a string of two solar cell units according to the invention connected to one another;
Fig. 6 a schematic lateral section view through a **second** embodiment of a string of two solar cell units according to the invention connected to one another;
Fig. 7 a schematic lateral section view through a **third** embodiment of a string of two solar cell units according to the invention connected to one another;
Fig. 8 a current-voltage response of the solar cell unit according to Fig. 1; and
Fig. 9a-c each a maximum power point (MPP) measurement for a) voltage, b) current, and c) power of a configuration according to Fig. 1.

### WAYS OF CARRYING OUT THE INVENTION

### Definitions:

The term "laterally" is understood as a direction parallel to a substrate layer of the respective element.

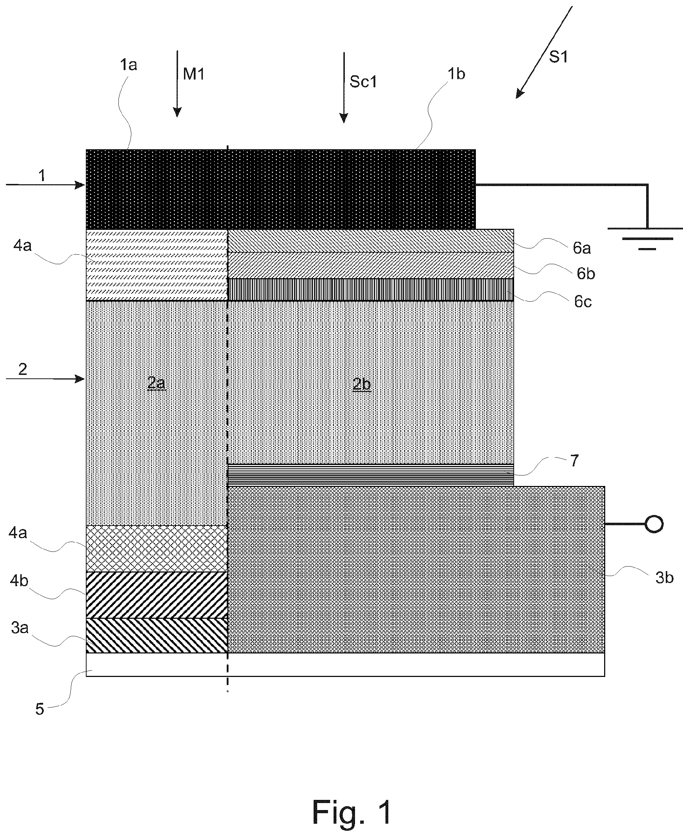

The term "thickness" in conjunction with a layer is interpreted here in the direction perpendicular to the substrate, that is e.g.: arrow M1 in Fig. 1.

A "perovskite material" has the general formula ABX3 wherein A is a monovalent cation, B is a divalent cation, and X is a monovalent anion.

In the context of the present invention, the term "co-integrated" is used for embodiments of the solar cell unit, in which the memristor and the solar cell share at least one layer, e.g. a substrate layer, or a semiconductor layer. In such embodiments, both elements are co-manufactured at the same time and are not arranged spatially apart from one another.

In the context of the present invention, the term "homogenous" in view of materials is understood as a layer of material which is not interrupted by another material. In other words, it means a block of the same material.

A memristor, short for memory resistor, is a type of resistive switching element. It changes its resistance based on the history of voltage and current applied to it. It "remembers" its resistance state even after the power is turned off.

An "active" electrode refers to the electrode that is actively involved in the collection and transfer of charge carriers (electrons or holes) generated by the absorption of light in the active layer of the solar cell

A "reactive" electrode refers to an electrode that participates in chemical reactions or interacts with the surrounding environment in a way that affects the performance of the memristor.

A "string" of solar cells or solar cell units is understood in the context of the entire document as an array of said elements.

For the sake of clarity, a "layer" is defined as parallel to the substrate layer, while a "channel" is defined as perpendicular, or as the case may be oblique, to the substrate layer. A channel according to the present definition also contains solid material, in the same way as a layer.

Generally, most of the embodiments of the solar cell unit described in the following are co-integrated. However, in one embodiment according to the invention the memristor and the solar cell unit are manufactured apart from one another and are electrically connected by wiring.

Using a co-integrated memristor/solar cell solar cell unit (also called "memsol" in the following) has the advantage that any external wiring is avoided. Moreover, not only every cell but also every active region can be protected separately by one memristor, thereby addressing drawbacks of bypass diodes known to the skilled person. Generally speaking, the memsol addresses known reverse bias instability of perovskite solar cells.

On the other hand, using a configuration with the memristor being an individual standalone element, it is possible to increase the flexibility of the design. For example, multiple solar cells may be protected by one single memristor, which will become apparent later in the description. Furthermore, manufacturing may be easier.

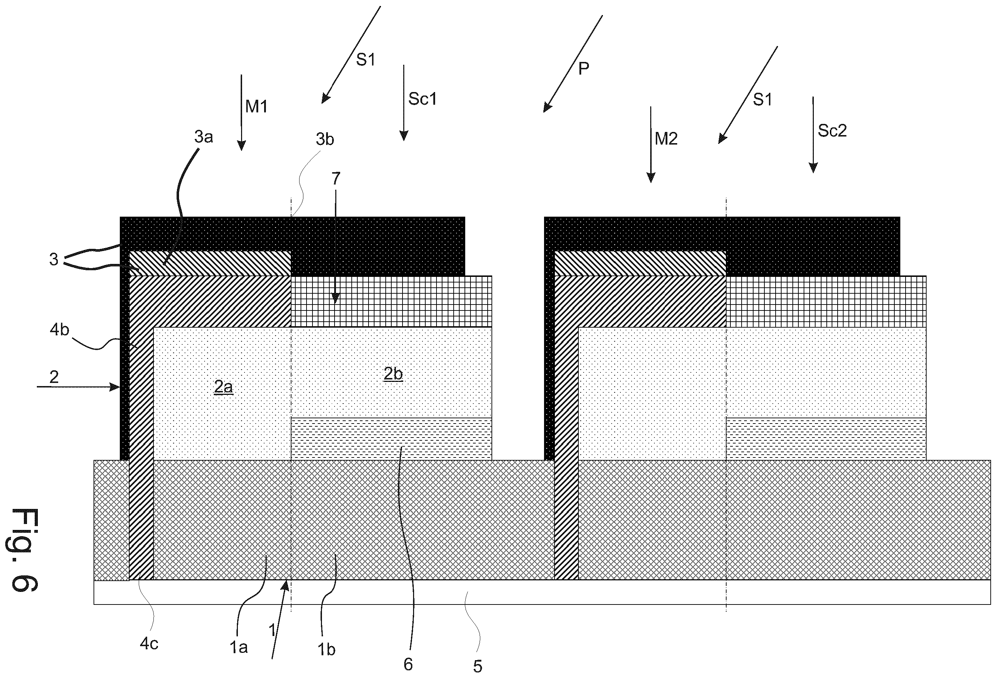

**Fig. 1** shows a schematic lateral section view through a first embodiment of a solar cell unit S1 according to the invention. In this embodiment, a solar cell Sc1 and a memristor M1 of the memsol S1 are co-integrated in a PIN-configuration, where PIN stands for: **P**-type layer, **I**ntrinsic layer, **N**-type layer. It is noted that a NIP-configuration, which stands for the opposite arrangement of the p-type and n-type layers, is also possible and shall be considered as equally disclosed, whereby the electrode layers are swapped and certain optional layers serving as hole/electron transport layers may be swapped as well. An example of a NIP-configuration is described in connection with Fig. 6.

In a basic configuration, the memristor comprises a first memristor electrode 1a, a memristor semiconductor part 2a, a second memristor electrode 3a and a memristor insulating layer 4b. The solar cell Sc1 comprises as stacked layers a first solar cell electrode 1b, a solar cell semiconductor part 2b and a second solar cell electrode 3b.

The first memristor electrode 1a and the first solar cell electrode 1b form together a first electrode 1 of the memsol. They are preferably made of the same homogenous material, i.e. there is no insulation between them.

The memristor semiconductor part 2a and the solar cell semiconductor part 2b form together a semiconductor layer 2 of the memsol. In this embodiment, they are preferably made of the same homogenous material, which is perovskite as described above. It is noted that in Fig. 1 the memristor semiconductor part 2a is thicker than the solar cell semiconductor part 2b. However, a vice-versa configuration or same thickness is also conceivable.

The second memristor electrode 3a is arranged on the substrate layer 5 and forms together with the second solar cell electrode 3b a second electrode layer 3 of the solar cell unit. They are preferably made of different materials.

The insulating layer 4b is arranged between the memristor semiconductor part 2a and the second memristor electrode 3a. The memristor insulating layer 4b is an organic (small molecule, polymer, etc.) or inorganic insulating layer, particularly a positive or a negative photoresist layer. Preferably, this insulating layer is made of PL177, a positive photoresist which can be patterned through lithography process. Other insulating materials are also conceivable, e.g. polymethyl methacrylate (PMMA).

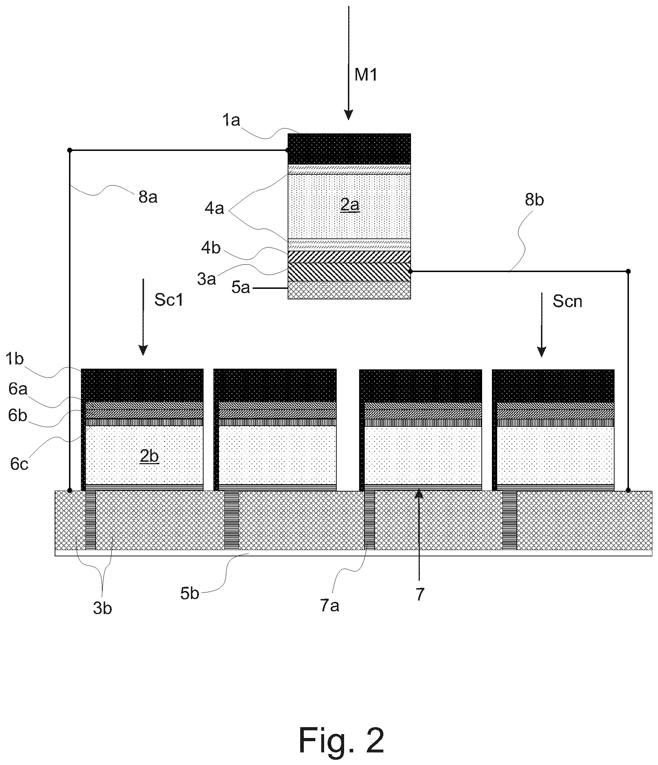

The solar cell and the memristor are arranged on a common substrate layer 5. This is the case for all co-integrated embodiments of the memsol described herein. In the embodiments in which the memristor is a separate unit, as mentioned, the solar cell and the memristor may have each a separate own substrate layer 5a, 5b (Fig. 2).

Additional optional layers described in the following may also be present for both elements, the memristor and the solar cell.

Regarding the insulating layer of the memristor, while the positive photoresist PL177 has the advantage that it allows for potential lithographic processing, it is known that PL177 has poor wetting properties. Therefore, when PL177 is chosen as the insulating layer, an additional insulating layer of silicon monoxide (SiO) is applied on it so as to facilitate contact to the semiconductor layer. But the SiO-layer is not required for other insulating materials.

As can be seen, the memristor semiconductor part 2a is sandwiched between two layers 4a of silicon monoxide. The upper layer of SiO in the figure serves to enhance stability of the solar cell unit.

The solar cell additionally comprises between the first solar cell electrode 1b and the solar cell semiconductor layer 2b an optional electron transfer layer. In this embodiment, the electron transfer layer preferably comprises, as seen in a direction towards the solar cell semiconductor layer or the substrate layer, three sublayers: first a benzocyclobutene layer 6a (also known as BCP), followed by a buckminsterfullerene layer 6b (also known as C60) and finally a piperazine dihydriodide layer 6c.

In this embodiment, the BCP layer improves the mechanical stability.

The C60 layer is an electron transport material and improves power conversion efficiency by reducing recombination losses by efficiently separating charge carriers (electrons and holes). This material shall be understood as including the simple fullerene or fullerene derivatives.

The piperazine dihydriodide layer also serves as an electron transport layer and has passivation properties in order to reduce surface defects or recombination at the interface between the perovskite and the C60 layer.

Furthermore, the solar cell Sc1 additionally comprises between the solar cell semiconductor layer 2b and the second solar cell electrode 3b a hole transfer layer 7, preferably substantially made of 4-(2-methoxyethoxy)-phenyl)-4'-[3-(4-pyridyl)phenyl]-phenyl]-carbazole (also called MEO-4PACZ). This material has good hole transport properties, thereby providing an efficient charge transport. Furthermore, it is relatively resistant to degradation, such as due to humidity and light exposure.

Generally, for the purposes of the present invention, a multitude of materials may be used as transport layers, basically any kind of transport layers with functionality of electron and/or hole transporting such as SAMs (Self-assembled monolayers) and/or Spiro-MeOTAD and/or Spiro-MeoTAD derivatives and/or Copper indium gallium selenide (CIGS) and/or phenyl-C61-butyric acid methyl ester (PCBM) and/or C60 and/or C70 and/or Copper(II) phthalocyanine (CuPc) and/or (Poly(3,4-ethylenedioxythiophene) polystyrene sulfonate) (PEDOT:PSS) and/or nickel oxide (NiOx) and/or titanium dioxide (TiO₂) and/or tin oxide (SnO₂) and/or zinc oxide (ZnO) and/or aluminum oxide (Al₂O₃) and/or molybdenum oxide (MoO₃) and/or tungsten oxide (WO₃) and/or poly(3-hexylthiophene) (P3HT) and/or polytriarylamine (PTAA) and/or graphene derivatives and/or transition metal dichalcogenides (e.g., MoS₂, WS₂) and/or other doping modifications (e.g., LiF, Li doping). Here it is not specified in detail which of the above materials are suitable as electron transport layer or as hole transport layer or as both, as the skilled person is familiar with the materials.

Finally, the second solar cell electrode 3b is arranged on the substrate 5. Generally, the second solar cell electrode 3b may border at least one side of the second memristor electrode 3a or show an overlap. Here it is arranged only bordering one lateral side of the second memristor electrode 3a.

The materials of the electrodes will be discussed in connection with the different layer arrangements of the different embodiments of the solar cell unit. The embodiment according to Fig. 1 may be considered as a basic preferred embodiment of a single solar cell unit.

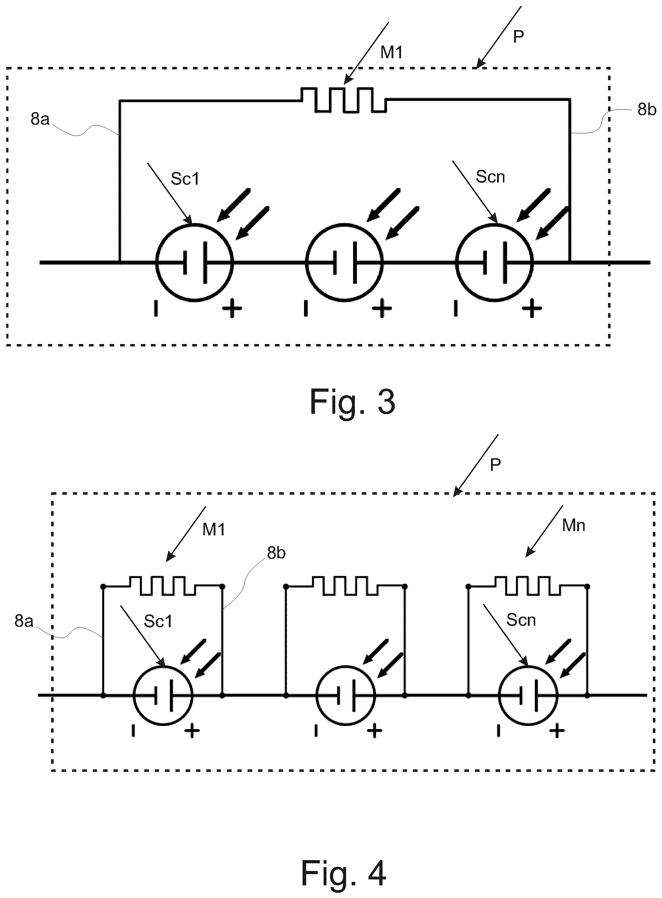

**Fig. 2** shows a schematic lateral section view through a second embodiment of a solar cell unit according to the invention, and **Fig. 3** a schematics of a configuration of a solar cell unit according to Fig. 2. In this embodiment, as can be seen in the figure, a single memristor M1 is electrically connected to a string of solar cells Sc1,...,Scn. The index "1" and "n" shall denote that the string of solar cells may contain an arbitrary number of solar cells within a technical reasonable limit. The solar cells of the string are connected to one another in series, in such a way that the first memristor electrode 1a is connected to the second solar cell electrode 3b of a first solar cell Sc1 of the string of solar cells and the second memristor electrode 3a is connected to a last solar cell Scn of the string of solar cells. In other words, a single memristor is connected in parallel to a series arrangement of multiple solar cells. In this embodiment, the memristor and the string of solar cells Sc1,...,Scn are each arranged on an own substrate layer 5a, 5b. While the layers, their arrangements and materials may be the same as already described in the context of Fig. 1, this embodiment has the advantage that a single memristor is used for protecting multiple solar cells, thereby reducing material costs and in some cases manufacturing costs, as simple layers can be deposited to yield each element (e.g the memristor) and requirements for the other element (e.g. the solar cell) don't have to be considered.

**Fig. 4** shows a schematics of an alternative configuration of a string of solar cell units.

While in Fig. 3 multiple solar cells are connected in parallel to a single memristor, the embodiment of Fig. 4 also shows a memristor M1 as a standalone element. However, in Fig. 4 it is electrically connected to exactly one solar cell in such a way that the first memristor electrode 1a is connected to the first solar cell electrode 1b and the second memristor electrode 3a is connected to the second solar cell electrode 3b. The memristor and the solar cell are each arranged on an own substrate layer 5a, 5b. In this embodiment, the solar unit cells M1,...,Mn may either be designed with a standalone memristor but the figure may also be interpreted to depict a structure according to Fig. 1 with individual co-integrated solar cell units connected in series. The description of Fig. 1 also applies here for this type of connection and will not be described in more detail again.

Generally, in the next embodiments, two adjacent solar cell units are shown in order to emphasize how they are connected to one another. In other words, the illustration may be interpreted as two adjacent solar cell units in a co-integrated configuration according to Fig. 4. The references M1, Sc1 and M2, Sc2 shall merely emphasize that two adjacent solar cell units are meant. Of course, the reader shall imagine a longer string of solar cell units repeating the respective connection pattern described in the context of each figure. While the layer configurations may differ from Fig. 1 in the following, it shall be assumed that the first embodiment of the solar cell unit according to Fig. 1 may also be adapted to match each solar cell unit of the now following embodiments. In the now following embodiments, the memristor M1 and the solar cell Sc1 are co-integrated and reside on the same substrate layer 5, which is not only common to the solar cell Sc1 and the memristor M1 of the first solar cell unit S1, but also to the solar cell Sc2 and the memristor M2 of the second solar cell unit S1.

Same reference numerals shall denote same or similar elements as described in connection with the foregoing figures. In the following only features are described, which are different to the basic configuration of Fig. 1.

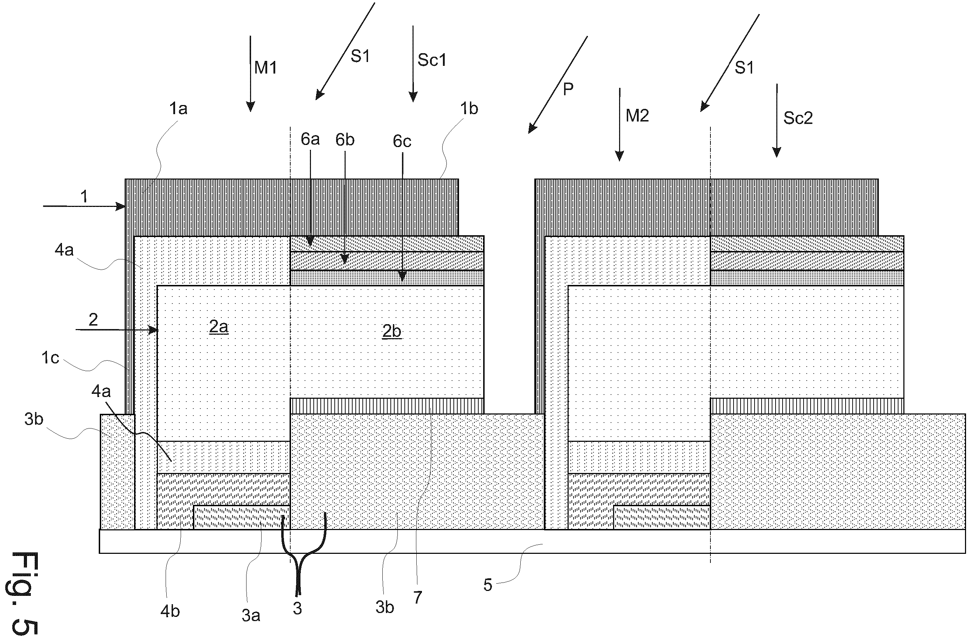

**Fig. 5** shows a schematic lateral section view through a first embodiment of a string ST1 of two solar cell units S1 according to the invention with a PIN-configuration and connected to one another.

In this embodiment, the first solar cell electrode 1b borders one side of the first memristor electrode 1a, being arranged laterally adjacent to one another and forming together the first electrode layer 1 of the solar cell unit. The first electrode layer is arranged opposite of the second electrode layer, so that together they sandwich all other layers.

The memristor semiconductor part 2a and the solar cell semiconductor part 2b are arranged laterally adjacent to one another, forming together a semiconductor layer 2. The memristor semiconductor part 2a is arranged between the first memristor electrode 1a and the second memristor electrode 3a and the solar cell semiconductor part 2b is arranged between the first solar cell electrode (1b) and the second solar cell electrode 3b.

The second solar cell electrode 3b borders one side of the second memristor electrode 3a. The second memristor electrode 3a and the second solar cell electrode 3b are arranged laterally adjacent to one another. As shown in the figure, the latter may be thicker than the second memristor electrode 3a and may border the insulating layer 4 (composed of the SiO layer 4a and the PL177 layer 4b) and the memristor semiconductor part 2a. In this embodiment, the second memristor electrode 3a borders the PL177-layer on both its semiconductor part and on the other lateral side. The SiO-layer surrounds the memristor semiconductor part 2a on three sides. Thus, there are not two distinctive SiO-layers (see Fig. 1) but rather two SiO-layers connected by a channel. When contemplating the second memristor M2, it becomes apparent that the SiO-channel, which ends at the substrate layer, improves the sideways electrical insulation provided by the PL177-layer to the second solar cell electrode of the previous solar cell unit Sc1.

As can be seen, each solar cell unit is connected to the adjacent next solar cell in such a way that its second solar cell electrode 3b is electrically connected to the first memristor electrode 1a of the next solar cell unit. For this, the first electrode layer has a channel 1c on the memristor side, which electrically connects to the second solar cell electrode of the previous solar cell unit.

It is preferred that the first electrode layer 1 is an active electrode. Accordingly, the second electrode layer, particularly the second memristor electrode 3a, is a reactive electrode.

It is furthermore preferred that the first electrode layer is substantially made of gold and/or of platinum and/or carbon and/or carbon derivatives, or of a conductive transparent material. It is noted that throughout the document the term "carbon derivatives" relates to graphite or carbon nanotubes or graphene.

It is furthermore preferred that the second memristor electrode 3a is substantially made of silver and/or copper.

It is furthermore preferred that the second solar cell electrode 3b is made of a transparent material, particularly fluorine-doped tin oxide or indium tin oxide.

**Fig. 6** shows a schematic lateral section view through a second embodiment of a string ST1 of two solar cell units S1 with according to the invention connected to one another. This embodiment illustrates a NIP-configuration with the memristor M1 and the solar cell Sc1 of each solar cell unit being co-integrated. It is noted that in the embodiments of the solar cell unit and photovoltaic module described so far, other layers may also be inverted to satisfy requirements of a NIP-configuration.

As can be seen in the figure, the first electrode layer 1 and the second electrode layer 3 are swapped, so that now the first electrode layer 1 is arranged on the substrate 5. The first memristor electrode 1a and the first solar cell electrode 1b are arranged laterally adjacent to one another, forming together the first electrode layer 1.

The memristor semiconductor part 2a and the solar cell semiconductor part 2b are arranged laterally adjacent to one another and are made by a homogenous material, forming together the semiconductor layer 2 with no difference to the embodiment of Fig. 5.

Certainly, the electron transfer layer 6 and the hole transfer layer 7 are swapped as well. But they are preferably configured with respect to materials and sublayers in the same way as described in connection with Fig. 1.

In this embodiment, no SiO layers are shown in order to emphasize that the insulating layer 4b may be present without the aid of said SiO-layer. But, of course, if PL177 is used as the insulating layer material, the SiO-layer(s) may be present also in this embodiment.

It is preferred that the first electrode layer 1 is an active electrode, as in the embodiment of Fig. 5, with the difference that it is arranged on the substrate in the NIP-configuration. Accordingly, the second electrode layer, particularly the second memristor electrode 3a, is a reactive electrode.

Preferably, the first electrode layer 1 is made of a transparent material, particularly substantially fluorine-doped tin oxide (FTO) or indium tin oxide (ITO). In other words, the first memristor electrode 1a and the first solar cell electrode 1b are both made of a homogenous material with no interruption between them.

Preferably, the second memristor electrode 3a is substantially made of silver and/or copper.

Preferably, the second solar cell electrode 3b is made of gold and/or of platinum or of a conductive transparent material and/or carbon and/or carbon derivatives.

The second solar cell electrode 3b borders three sides of the second memristor electrode 3a, forming together the second electrode layer 3 of the solar cell unit. The second electrode layer 3 is arranged opposite of the first electrode layer 1. When comparing Fig. 5 and Fig. 6, it is apparent that in Fig. 5 the second memristor electrode 3a and the second solar cell electrode 3b are arranged laterally adjacent to one another but in Fig. 6 the second solar cell electrode 3b is wrapped around the second memristor electrode 3a. This arrangement is due to the necessity of providing the channel 1c for connection between two adjacent solar cell units and due to the fact that the second electrodes of the memristor and the solar cell are made of different materials. However, in this context it is noted that the embodiments of the solar cell unit with PIN-configuration may also feature, in their case the second memristor electrode 3a, bordering the second solar cell electrode 3b not only laterally, but also extending between the second memristor electrode 3a and the substrate layer 5, and potentially also on the other lateral side of the second memristor electrode 3a.

In this embodiment, all solar cell units Sc1, Sc2 share the first solar cell electrode 1b. For each solar cell unit, the first solar cell electrode 1b also extends on the memristor side between the memristor semiconductor part 2a and the substrate layer 5.

As can be seen, the insulating layer 4b has a channel 4c, which extends until the substrate layer 5. This channel is intended for interrupting the first electrode layer on the memristor side M1 in order to electrically separate the first electrode layers of adjacent solar cell units. It is preferred that the insulating material 4c is a positive or a negative photoresist material, particularly a polymeric material or Spiro[fluorene-9,9'-[9H-carbazole]-3',3"-diyl]bis(methoxyethylphenyl)methanol (also called Spiro-Me-OTAD). It can be the same material as used for the insulating layer 4b, particularly PL177. Each solar cell unit is electrically connected to an adjacent solar cell unit in such a way that the first solar cell electrode 1b is electrically connected to the second solar cell electrode 3b of the adjacent solar cell unit Sc2. Preferably, the connection is done by a channel made of the same material like the second solar cell electrode 3b.

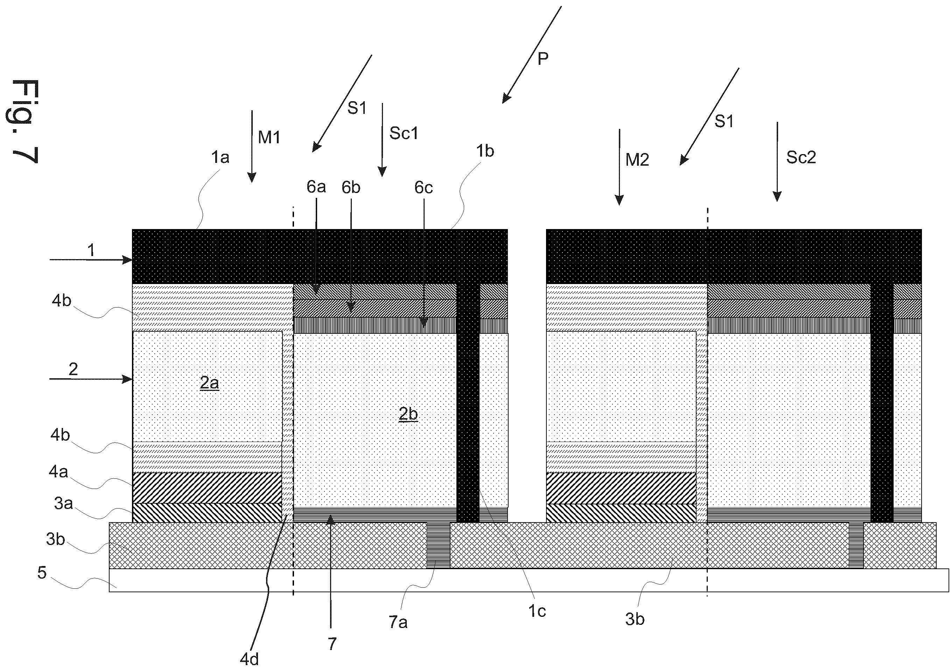

**Fig. 7** shows a schematic lateral section view through a third embodiment of a string ST1 of two solar cell units S1 with a PIN-configuration according to the invention connected to one another. The substrate layer 5 is common to the memristor and the solar cell of each solar cell unit. The first electrode layer is arranged opposite of the second electrode layer.

In this embodiment, the first solar cell electrode 1b borders one side of the first memristor electrode 1a. Preferably, the first memristor electrode 1a and the first solar cell electrode 1b are arranged laterally adjacent to one another, forming together a first electrode layer 1 of the solar cell unit.

The memristor semiconductor part 2a and the solar cell semiconductor part 2b are arranged laterally adjacent to one another, forming a semiconductor layer 2. However, here the memristor semiconductor part 2a and the solar cell semiconductor part 2b are separated by a channel 4d of an insulating material, preferably SiO. In other words, the memristor semiconductor part 2b is entirely embedded in SiO in this exemplary embodiment. In this embodiment, the two semiconductor parts 2a and 2b may be manufactured of different materials, e.g. of different perovskite types. This configuration leading to such separation may also apply for the other co-integrated embodiments.

The second solar cell electrode 3b borders one side of the second memristor electrode 3a, in such a way that the second memristor electrode 3a is arranged between the second solar cell electrode 3b and the insulating layer 4b, forming together a second electrode layer 3 of the solar cell unit. As can be seen in conjunction with Fig. 1 or 5, this configuration is different, as in Fig. 1 or 5 the second memristor electrode and the second solar cell electrode are arranged laterally adjacent to one another and both on the substrate layer 5. Here, the second solar cell electrode 3b is arranged on the substrate layer 5 and the second memristor electrode 3a is not arranged on the substrate layer. This configuration may however also be used for the embodiment of Fig. 1 and 5 and vice versa.

All other optional layers may preferably be configured with respect to materials and sublayers in the same way as described in connection with Fig. 1.

Similarly, to the NIP-configuration of Fig. 6, all solar cell units Sc1, Sc2 share the second solar cell electrode 3b (in Fig. 6 the first electrode layer). For each solar cell unit, the second solar cell electrode 3b also extends on the memristor side between the second memristor electrode 3a and the substrate layer 5 and is interrupted on the solar cell side Sc1 (in Fig. 6 on the memristor side M1) by a channel 7a made of a hole transport material, preferably Spiro[fluorene-9,9'-[9H-carbazole]-3',3"-diyl]bis(3,4-dimethoxyphenyl)methanol (also called Spiro-OMeTAD). Each solar cell unit is electrically connected to an adjacent solar cell unit in such a way that the first solar cell electrode 1b is electrically connected to the second solar cell electrode 3b of the adjacent solar cell unit Sc2. This is preferably accomplished by a channel 1c made of the same material like the first solar cell electrode (like in the embodiment of Fig. 5 or 6), which protrudes through all layers until it reaches the second electrode layer 3 of the next solar cell unit M2, Sc2.

As mentioned, generally all embodiments of the solar cell units described so far may have either a PIN- or a NIP-configuration. Each of them has only been described for the one or the other configuration as exemplary embodiment, which is not intended as a limitation to the respective configuration.

With regard to the photovoltaic module P, it may be configured in many possible ways. For example, it may consist of a string of either one of the embodiments of Fig. 5 to 7. But it may also be configured like in Fig. 3 with one memristor protecting multiple solar cells Sc1,...,Scn (illustrated with the dashed rectangle P) or as a string of such "P-rectangles" connected in series. The photovoltaic module may also be configured according to Fig. 4, either encompassing a string of the configurations of solar cell units of Fig. 5-7 for the co-integrated embodiments, or also covering a string of solar cell units in the configuration with a standalone memristor M1 wired to a standalone solar cell Sc1.

In the following, tests of a solar cell unit according to the invention are described in more detail.

Generally said, in order to protect a solar cell by using a memristor in parallel, certain requirements must be met by the memristor's performance. To ensure current conduction and minimal power loss during reverse and forward bias, low On-state and high Off-state resistivities are essential. Regardless of the reverse voltage and breakdown voltage values, switching speed (how fast memristors switch states) must be high enough to prevent solar cell degradation. The set voltage (the voltage the memristor needs to switch from Off to On-state) must be the minimum possible and the reset voltage (the minimum voltage memristor needs to switch back from On to Off-state) must be below the MPP point (maximum power point) of the high output solar cell. A basic electrode/perovskite/electrode structure exhibits, as desired, switching behavior. However, it is preferred incorporating an insulating layer between the perovskite semiconductor layer and the electrodes helps preventing unwanted perovskite- active electrode reactions that may impact performance of the memristor. Additionally, this measure can enhance the On/Off current ratio by effectively reducing the off-current. This is important for a solar cell, where minimizing leakage current under forward bias in the presence of light is essential. As mentioned, the positive photoresist PL177, which also allows for potential lithographic processing, is preferably used as an insulating layer. This enables the implementation of a memristor within the active area of the solar cell to reduce power loss caused by the limited light-harvesting surface. However, while a small memristor of just a few micrometers can typically generate a few mA of current, in the present invention the memristor is placed in the dead region of the solar cell, where the respective solar cell electrode (FTO, ITO) on the side of the substrate is etched. Since the lithography process typically involves developers that perovskite is sensitive to, PL177 is preferably deposited between the perovskite semiconductor layer and the electrode layer on the side of the substrate, allowing PL177 to be applied first. However, as mentioned before, the wetting properties of PL177 are not ideal for perovskite deposition and the deposition process partially dissolves PL177. To address this, it is preferred to introduce a thin SiO-layer between the perovskite semiconductor layer and the PL177 insulating layer by evaporation. This not only improves wetting properties but also protects the PL177-layer from dissolution during perovskite deposition. Memristor performance metrics are largely influenced by the type of electrode used, which can be either active or reactive. To meet the conditions outlined above, the memristor must switch on as quickly as possible under reverse bias to protect the solar cell. Additionally, the voltage drops or set voltage of the memristor should be minimized. These requirements are best achieved with a memristor utilizing an active electrode, with silver being a particularly suitable candidate. As previously mentioned, the memristor needs to turn on under reverse bias and turn off under forward bias. As it is preferred for co-integration that the electrode layers are shared between the memristor and the solar cell, in the PIN-configuration silver is preferred as the second memristor electrode and is deposited on the substrate layer preferably made of glass, in the sections where the second solar cell electrode (FTO/ITO) 3b is etched. As for the reactive electrode, gold is preferred as the first electrode layer shared between the memristor and the solar cell. As mentioned, an additional SiO-layer between the perovskite semiconductor layer 2 and the first electrode layer made of gold is preferably added, which enhances the stability of the solar cell unit, although not essential for the memristor's performance metrics.

Thus, for co-integration of the memristor and the solar cell, a PIN layer structure according to Fig. 1 is preferred and has been tested, comprising, starting from the glass substrate layer: Ag / PL177 / SiO / (FA_{0.95}MA_{0.05})_{0.95}Cs_{0.05}Pb(I_{0.95}Br_{0.05})₃ / SiO / Au for the memristor side and ITO / Meo-4PACZ / (FA_{0.95}MA_{0.05})_{0.95}CS_{0.05}Pb(I_{0.95}Br_{0.05})₃ / piperazinedihydriodide / PCBM / Ba-thocuproine / Au for the solar cell side. Lock-in thermography tests under reverse bias have revealed a conductive region observed at the boundary of the active region of the solar cell, indicating that the memristor successfully activates under reverse bias.

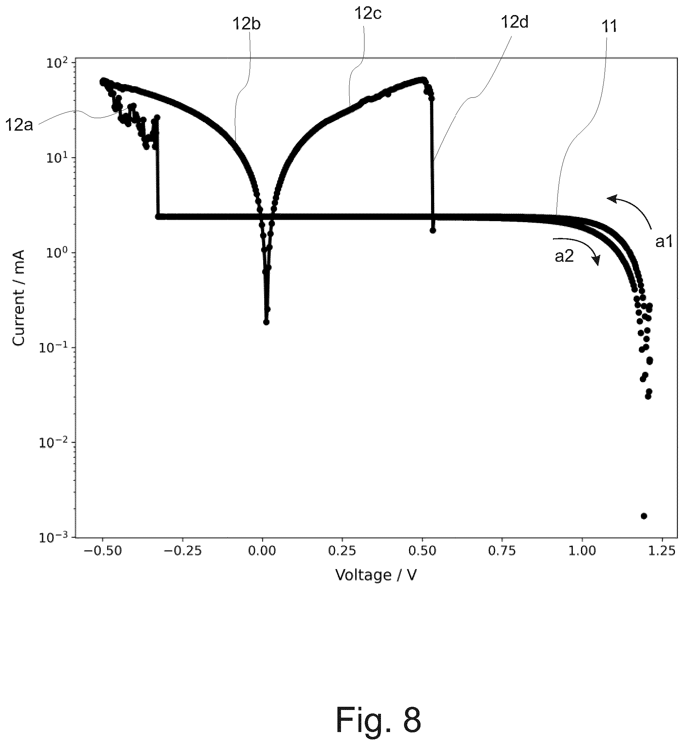

**Fig. 8** shows a current-voltage response of the solar cell unit according to Fig. 1 under light.

The curve 11 illustrates a standard backward scan of the solar cell unit, beginning at 1.21 V (arrow a1) and moving to -0.3 V. At -0.3 V, the reverse bias triggers the memristor to switch from the off-state to the on-state, causing a sharp increase in current to about 20 mA. Further increasing the reverse bias raises the memsol current to approximately 70 mA (curve 12). During the subsequent forward scan, which starts at -0.5 V, the memristor remains in the on-state as the voltage increases up to about 0.6 V. In this range, the memsol current initially decreases (curve 12b) and then rises again (curve 12c), reaching about 70 mA. At 0.6 V, the forward bias prompts the memristor to reset back to the off-state (curve 12d), reducing the current and returning the device to its normal solar cell behavior as the voltage continues to 1.21 V (curve 11, arrow a2). As shown in Fig. 8, when the memristor triggers on, the current of the memsol increases by tens of mA. This range of current is sufficient to handle the current of a high output cell with an area of few cm² connected in series.

To examine potential power loss caused by memristor's resistivity in the Off-state, an additional current-voltage measurement was performed under illumination, utilizing two current source meters to independently measure memristor and solar cell part currents, (not shown). It has been found that memristor's current before set and after reset, is around 10⁻¹¹ A and 10⁻¹⁰ A at 0 V and 1.2 V, respectively. Advantageously, such high resistivity is sufficient to prevent any power loss, even under weak illumination.

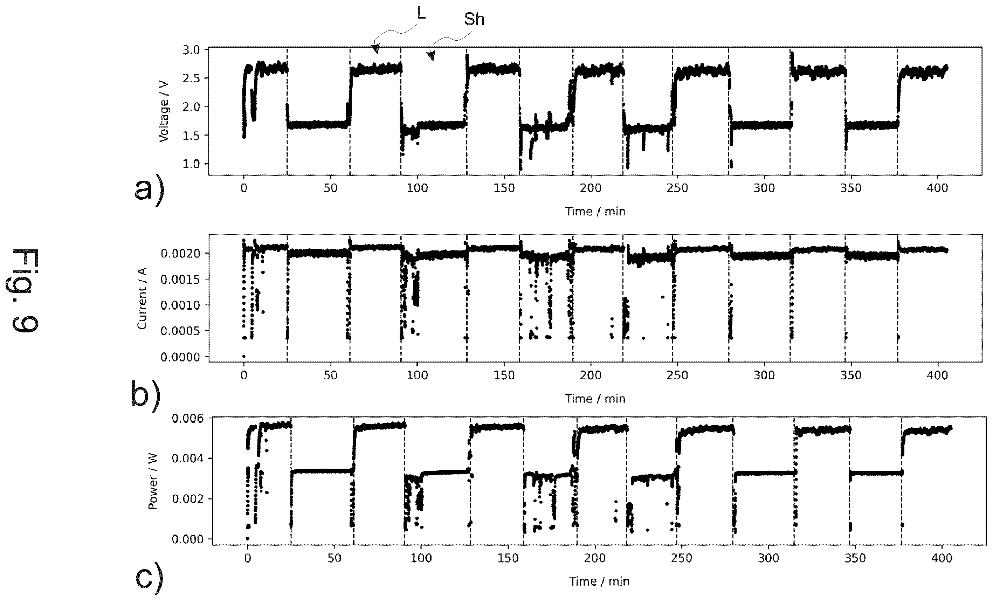

**Fig. 9a****-c** show each a maximum power point (MPP) measurement for a) voltage, b) current, and c) power of a configuration according to Fig. 4.

To investigate memsol in a practical application, three solar cell units have been connected in series and kept under light (L). An MPPT (Maximum Power Point Tracker) was used to keep the solar cell units operating at their MPP. By shading one of the solar cell units, it was kept under reverse bias periodically (every half an hour). Fig. 9a, 9b, and 9c show the synchronized measurements of voltage, current, and power over time, respectively. As shown in Fig. 9a, when the blocked solar cell unit goes under the shade (Sh), the MPP voltage drops and varies in the range of 1.65 V to 1.72 V. However, as can be seen in Fig. 9b in the respective shade-cycle Sh, the total current remains roughly unchanged at 2 mA, showing that the memristor successfully switched on in this time period. When the blocked solar cell unit returns back to light, the MPP voltage increases and varies in the range of 2.5 V and 2.7 V while the current remains substantially constant. As shown in Fig. 9c, the total power generated by the three connected cells remains constant throughout the measurement period.

While presently preferred embodiments of the invention are shown and described in this document, it is distinctly understood that the invention is not limited thereto but may be embodied and practiced in other ways within the scope of the following claims. Therefore, terms like "preferred" or "in particular" or "particularly" or "advantageously", etc. signify optional and exemplary embodiments only.

## Claims

1. Solar cell unit (S1) comprising:
- at least a solar cell (Sc1), and
- at least a memristor (M1),
wherein the memristor (M1) is connected in parallel to the solar cell (Sc1).

2. Solar cell unit according to claim 1, wherein the memristor comprises as stacked layers:
- a first memristor electrode (1a),
- a memristor semiconductor part (2a),
- a second memristor electrode (3a),
- a memristor insulating layer (4b), wherein the insulating layer (4b) is arranged between the memristor semiconductor part(2a) and the second memristor electrode (3a), and
wherein the solar cell comprises as stacked layers:
- a first solar cell electrode (1b),
- a solar cell semiconductor part (2b), and
- a second solar cell electrode (3b),
wherein the solar cell and the memristor are each arranged on a substrate layer (5), wherein either the solar cell (Sc1) and the memristor (M1) have each a separate own substrate layer or the solar cell (Sc1) and the memristor (M1) have a common substrate layer.

3. Solar cell unit according to claim 2,
wherein the memristor semiconductor part (2a) and the solar cell semiconductor part (2b) are substantially made of a perovskite material, particularly chosen from: lead-containing all-inorganic and/or organic-inorganic hybrid perovskites, lead-free perovskite and/or oxides perovskite compositions and/or non-oxides perovskite compositions.

4. Solar cell unit according to one of the claims 2 to 3, wherein the solar cell (Sc1) additionally comprises between the first solar cell electrode (1b) and the solar cell semiconductor layer (2b) an electron transfer layer (6), particularly wherein the electron transfer layer (6) comprises, as seen in a direction towards the solar cell semiconductor layer, first a benzocyclobutene layer (6a), followed by a buckminsterfullerene layer (6b) and followed by a piperazine dihydriodide layer (6c).

5. Solar cell unit according to one of the claims 2 to 4, wherein the solar cell (Sc1) additionally comprises between the solar cell semiconductor layer (2b) and the second solar cell electrode (3b) a hole transfer layer (7), particularly substantially made of 4-(2-methoxyethoxy)-phenyl)-4'-[3-(4-pyridyl)phenyl]-phenyl]-carbazole.

6. Solar cell unit according to one of the claims 2 to 5, wherein either
the semiconductor layer (2) is made of a homogenous material, or
the semiconductor layer (2) is laterally divided into the memristor semiconductor part (2a) and the solar cell semiconductor part (2b) by an insulating material (4b), particularly by silicon monoxide.

7. Solar cell unit according to one of the claims 2 to 6, wherein the memristor (M1) and the solar cell (Sc1) are co-integrated, wherein the substrate layer (5) is common to the memristor and the solar cell and
- wherein the second solar cell electrode (3b) borders or overlaps with at least one side of the second memristor electrode (3a), particularly either
wherein the second memristor electrode (3a) and the second solar cell electrode (3b) are arranged laterally adjacent to one another or
the second memristor electrode (3a) is arranged between the second solar cell electrode (3b) and the insulating layer (4b), forming together a second electrode layer (3) of the solar cell unit,
wherein the second solar cell electrode (3) is arranged on the substrate layer (5),
- wherein the memristor semiconductor part (2a) and the solar cell semiconductor part (2b) are arranged laterally adjacent to one another, forming together a semiconductor layer (2), wherein the memristor semiconductor part (2a) is arranged between the first memristor electrode (1a) and the second memristor electrode (3a) and the solar cell semiconductor part (2b) is arranged between the first solar cell electrode (1b) and the second solar cell electrode (3b),
- wherein the first solar cell electrode (1b) borders at least one side of the first memristor electrode (1a), particularly wherein the first memristor electrode (1a) and the first solar cell electrode (1b) are arranged laterally adjacent to one another, forming together a first electrode layer (1) of the solar cell unit, wherein the first electrode layer is arranged opposite of the second electrode layer.

8. Solar cell unit according to claim 7,
- wherein the first electrode layer (1) is an active electrode, particularly substantially made of gold and/or of platinum and/or carbon and/or carbon derivatives, or of a conductive transparent material,
- wherein the second memristor electrode (3a) is a reactive electrode, particularly substantially made of silver and/or copper, and
- wherein the second solar cell electrode (3b) is made of a transparent material, particularly fluorine-doped tin oxide or indium tin oxide, or wherein the second solar cell electrode (3b) is made of an opaque material, particularly of a metal such as aluminium, in case the first electrode layer (1) is made of the conductive transparent material.

9. Solar cell unit according to one of the claims 2 to 5, wherein the memristor (M1) and the solar cell (Sc1) are co-integrated, wherein the substrate layer (5) is common to the memristor and the solar cell and
- wherein the first solar cell electrode (1b) borders at least one side of the first memristor electrode (1a), particularly wherein the first memristor electrode (1a) and the first solar cell electrode (1b) are arranged laterally adjacent to one another, forming together a first electrode layer (1) of the solar cell unit, wherein the first electrode layer is arranged on the substrate layer (5),
- wherein the memristor semiconductor part (2a) and the solar cell semiconductor part (2b) are arranged laterally adjacent to one another, forming together a semiconductor layer (2), wherein the memristor semiconductor part (2a) is arranged between the first memristor electrode (1a) and the second memristor electrode (3a) and the solar cell semiconductor part (2b) is arranged between the first solar cell electrode (1b) and the second solar cell electrode (3b),
- wherein the second solar cell electrode (3b) borders at least one side of the second memristor electrode (3a) forming together a second electrode layer (3) of the solar cell unit, wherein the second electrode layer (3) is arranged opposite of the first electrode layer.

10. Solar cell unit according to claim 9,
- wherein the first electrode layer (1) is an active electrode made of a transparent material, particularly substantially of fluorine-doped tin oxide or indium tin oxide, and
- wherein the second memristor electrode (3a) is a reactive electrode, particularly substantially made of silver and/or copper, and
- wherein the second solar cell electrode (3b) is made of gold and/or of platinum or of a conductive transparent material.

11. Solar cell unit according to one of the claims 2 to 5, wherein either
the memristor (M1) is a standalone element and is electrically connected to exactly one solar cell in such a way that the first memristor electrode (1a) is connected to the first solar cell electrode (1b) and the second memristor electrode (3a) is connected to the second solar cell electrode (3b), wherein the memristor and the solar cell are each arranged on an own substrate layer (5a; 5b), or
the memristor (M1) is electrically connected to a string of solar cells (Sc1,...,Scn), the solar cells of which are connected to one another in series, in such a way that the first memristor electrode (1a) is connected to the second solar cell electrode (3b) of a first solar cell (Sc1) of the string of solar cells and the second memristor electrode (3a) is connected to a last solar cell (Scn) of the string of solar cells, wherein the memristor and the string of solar cells (Sc1,...,Scn) and are each arranged on an own substrate layer (5a; 5b).

12. Photovoltaic module (P) comprising a string of solar cell units according to one of the claims 1 to 11.

13. Photovoltaic module according to claim 12 and claim 7, or according to claim 12 and claim 8,
wherein all solar cell units (Sc1, Sc2) share the second solar cell electrode (3b), wherein for each solar cell unit the second solar cell electrode (3b) also extends on the memristor side between the second memristor electrode (3a) and the substrate layer (5) and is interrupted on the solar cell side (Sc1) by a hole transport material (7a), particularly wherein the hole transport material (7a) is Spiro[fluorene-9,9'-[9H-carbazole]-3',3"-diyl]bis(3,4-dimethoxyphenyl)methanol, wherein each solar cell unit is electrically connected to an adjacent solar cell unit in such a way that the first solar cell electrode (1b) is electrically connected to the second solar cell electrode (3b) of the adjacent solar cell unit (Sc2), particularly by a channel (1c) made of the same material like the first solar cell electrode.

14. Photovoltaic module according to claim 12 and claim 9, or according to claim 12 and claim 10, wherein all solar cell units (Sc1, Sc2) share the first solar cell electrode (1b), wherein for each solar cell unit the first solar cell electrode (1b) also extends on the memristor side between the memristor semiconductor part (2a) and the substrate layer (5) and is interrupted on the memristor side (M1) by an insulating material (4c), particularly wherein the insulating material (4c) is a positive or a negative photoresist material or Spiro[fluorene-9,9'-[9H-carbazole]-3',3"-diyl]bis(methoxyethylphenyl)methanol, particularly a polymeric material, wherein each solar cell unit is electrically connected to an adjacent solar cell unit in such a way that the first solar cell electrode (1b) is electrically connected to the second solar cell electrode (3b) of the adjacent solar cell unit (Sc2), particularly by a channel (1c) made of the same material like the second solar cell electrode.

15. Photovoltaic module according to claim 12 and claim 7, or according to claim 12 and claim 8, wherein each solar cell unit is connected to the adjacent next solar cell in such a way that its second solar cell electrode (3b) is electrically connected to the first memristor electrode (1a) of the next solar cell unit.
